# EUROPEAN PATENT APPLICATION

(11) **EP 2 657 978 A1**
(43) Date of publication of application: **30.10.2013**
(21) Application number: 11857851.7
(22) Date of filing: 28.12.2011
(51) Int. Cl.: H01L 31/0224, H01L 31/0747, H01L 31/18

(54) **PHOTOELECTRIC CONVERTER AND METHOD FOR PRODUCING SAME**

(30) Priority: 31.01.2011 JP 2011018320
(71) Applicant: Sanyo Electric Co., Ltd., Osaka 570-8677 (JP)
(72) Inventor: NARITA, Tomoki, Osaka-shi, Osaka 540-6207 (JP); NAKAMURA, Yuya, Osaka-shi, Osaka 540-6207 (JP); TAIRA, Shigeharu, Osaka-shi, Osaka 540-6207 (JP)
(74) Representative: Klunker . Schmitt-Nilson . Hirsch
(86) International application number: PCT/JP2011/080521
(87) International publication number: WO 2012/105155

(57) **Abstract**

A photoelectric converter (10) is provided with a photoelectric conversion unit (20), a light-receiving-surface electrode (30) provided on the light-receiving surface of the photoelectric conversion unit (20), and a rear-surface electrode (40) provided on the rear surface of the photoelectric conversion unit (20). The rear-surface electrode (40) includes a transparent conductive film (41) layered on the rear surface of the photoelectric conversion unit (20), and a metallic film (42) layered on substantially the entire surface of the transparent conductive film (41) with the exception of an end edge region (A3).

## Description

### [TECHNICAL FIELD]

The present invention relates to photoelectric converters and methods for producing the same.

### [BACKGROUND ART]

Patent Document 1 discloses a photoelectric converter which is provided with a photoelectric conversion unit, a light-receiving surface electrode provided on a light-receiving surface of the photoelectric conversion unit, and a rear surface electrode provided on the rear surface of the photoelectric conversion unit. In this photoelectric converter, each of the light-receiving surface electrode and the rear surface electrode is provided with two or more finger electrode units and two or more busbar electrode units connected to the finger electrode units.

### [RELATED ART DOCUMENT]

### [Patent Document]

Patent Document 1: JP 2009-290234 A

### [DISCLOSURE OF THE INVENTION]

### [Problems to be Solved by the Invention]

In photoelectric converters such as solar cells, transmittance of light in the infrared region may be problematic. As the photoelectric conversion units have come to have thinner layers, transmittance of light in other regions has also become problematic.

However, when a metal layer such as a busbar electrode unit or the like is formed on a rear surface of a photoelectric converter, there is a risk of a defect energy level caused by metal atoms in the metal layer diffusing into a semiconductor layer of the photoelectric conversion unit. Such a defect energy level may lower photoelectric conversion efficiency of the photoelectric converter by trapping carriers which have been generated in the photoelectric conversion unit.

### [Means for Solving the Problems]

A photoelectric converter according to the present invention includes a photoelectric conversion unit; a light-receiving surface electrode disposed on a light-receiving surface of the photoelectric conversion unit; and a rear surface electrode disposed on a rear surface of the photoelectric conversion unit; wherein the rear surface electrode comprises a transparent conductive film layered on the rear surface of the photoelectric conversion unit; and a metal film layered on substantially the entire surface of the transparent conductive film except for an edge area.

A method for manufacturing a photoelectric converter according to the present invention includes preparing a photoelectric conversion unit; placing a mask covering at least apart of an edge area on a photoelectric conversion unit and layering a transparent conductive film on an area on the photoelectric conversion unit except for the edge area covered by the mask; and with the transparent conductive film attached to the mask, a metal film is layered on an area on the transparent conductive film. Alternatively, a method for manufacturing a photoelectric converter according to the present invention may include preparing a photoelectric conversion unit; placing a first mask covering at least a part of an edge area on a photoelectric conversion unit and layering a transparent conductive film on an area on the photoelectric conversion unit except for the edge area which is covered by the first mask; and placing a second mask covering at least a part of an edge area on the transparent conductive film and layering a metal film on an area on the transparent conductive film except for the edge area covered by the second mask.

### [Effects of the Invention]

According to the present invention, a photoelectric converter having improved light conversion efficiency and a manufacturing method of the same are provided.

### [BRIEF DESCRIPTION OF THE DRAWINGS]

FIG. 1 shows a photoelectric converter according to an embodiment of the present invention viewed from a light-receiving surface side.
FIG. 2 shows a photoelectric converter according to an embodiment of the present invention viewed from a rear surface side.
FIG. 3 shows a schematic diagram of a cross-sectional view taken along the line B-B in FIGs. 1 and 2.
FIG. 4 shows a variation of a rear surface electrode.
FIG. 5 shows a schematic diagram of part of a manufacturing process of a photoelectric converter according to an embodiment of the present invention.
FIG. 6 shows a variation of a manufacturing process of a photoelectric converter according to an embodiment of the present invention.
FIG. 7 shows a variation of a protruding electrode.
FIG. 8 shows another variation of a protruding electrode.

### [BEST MODE FOR CARRYING OUT THE INVENTION]

A photoelectric converter 10 according to an embodiment of the present invention and a method for manufacturing the same are described below by referring to the drawings. It should be noted that the embodiments shown below are provided merely as examples. The present invention is not limited to the embodiments shownbelow. Further, the drawings referred to in the embodiments are schematically illustrated, and thus the dimensional ratios or the like shown in the drawings may be different from the dimensional ratios of the actual elements. Dimensional ratios or the like of a specific element should be determined by referring to the description below.

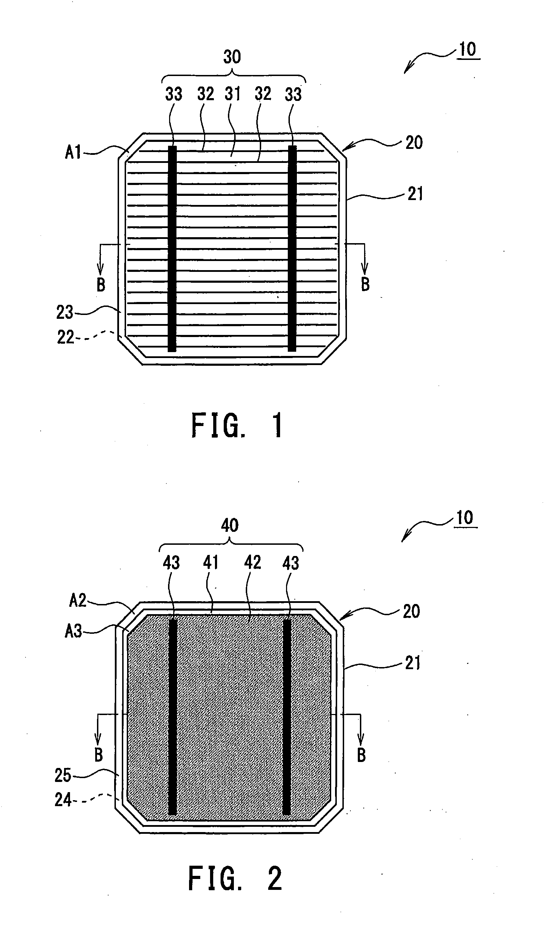

First, a configuration of the photoelectric converter 10 is described below by referring to FIGs. 1 to 4.

FIG. 1 shows the photoelectric converter 10 viewed from a light-receiving surface side, while FIG. 2 shows the photoelectric converter 10 viewed from a rear surface side of the photoelectric converter 10. As shown in FIGs. 1 and 2, the photoelectric converter 10 is provided with a photoelectric conversion unit 20 and a light-receiving surface electrode 30 provided on a light receiving surface of the photoelectric conversion unit 20, and a rear surface electrode 40 provided on a rear surface of the photoelectric conversion unit 20. The "light-receiving surface" indicates a main incident surface of light from outside of the converter. For example, when assembling a module such as a solar cell including the photoelectric converter 10, more than 50% to 100% of the incident light to the device comes from the light-receiving surface. The "rear surface" indicates a surface opposite the light-receiving surface.

The photoelectric conversion unit 20 is a member to generate carriers (electrons and holes) by receiving light such as solar light. In the photoelectric converter 10, the carriers generated by the photoelectric conversion unit 20 are collected by the light-receiving surface electrode 30 and the rear surface electrode 40. The carriers are retrieved outside as electrical energy by assembling the photoelectric converter 10 in a module by electrically connecting wiring members (not shown) to the light-receiving surface electrode 30 and the rear surface electrode 40. The photoelectric conversion unit 20 is provided with an n-type single crystalline silicon substrate 21 which is a crystalline semiconductor substrate having a substantially square shape.

As shown in FIG. 1, on the light-receiving surface of the n-type single crystalline silicon substrate 21, the photoelectric conversion unit 20 is provided with a p-type amorphous silicon film 23 layered via an i-type amorphous silicon film 22. A transparent conductive film 31 included in the light-receiving surface electrode 30 is layered on the light-receiving surface of the p-type amorphous silicon film 23. Further, finger electrode units 32 and busbar electrode units 33 for collecting electrical power generated by the photoelectric conversion unit 20 are formed on the transparent conductive film 31.

As shown in FIG. 2, on the rear surface of the n-type single crystalline silicon substrate 21, the photoelectric conversion unit 20 is provided with an n-type amorphous silicon film 25 layered via an i-type amorphous silicon film 24. A transparent conductive film 41 included in the rear surface electrode 40 is layered on the rear surface of the n-type amorphous silicon film25. Further, a metal film 42 for collecting electrical power generated by the photoelectric conversion unit 20 is formed on the transparent conductive film 41. Protruding electrodes 43 which are used as connecting units to the wire members are provided on the metal film 42.

In other words, the photoelectric conversion unit 20 has a configuration in which amorphous semiconductor thin films are layered on both surfaces of a crystalline semiconductor substrate. Specifically, the photoelectric conversion unit 20 has a layered configuration in which a p-type amorphous silicon film 23, i-type amorphous silicon film 22, n-type single crystal silicon substrate 21, i-type amorphous silicon film 24, and n-type amorphous silicon film 25 are layered in this order. In this layered configuration, the p-type amorphous silicon film 23 side is the light-receiving surface side.

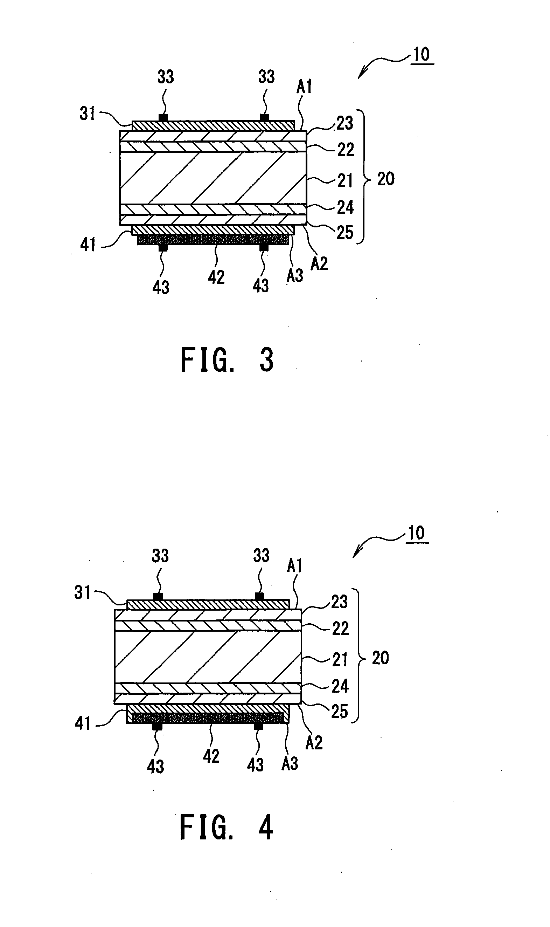

The configuration of the photoelectric converter 10 is further described in detail below by referring to FIG. 3 (cross-sectional view taken along the line B-B in FIGs. 1 and 2) as appropriate, in addition to FIGs. 1 and 2.

As shown in FIG. 3, the photoelectric conversion unit 20 is provided with the i-type amorphous silicon film 22 layered on the entire light-receiving surface of the n-type single crystal silicon substrate 21 and the i-type amorphous silicon film 24 layered on the entire rear surface of the n-type single crystal silicon substrate 21. It should be noted that the i-type amorphous silicon films 22, 24 may be layered on the entire light-receiving surface and the rear surface of the n-type single crystal silicon substrate 21 except for an edge area. The i-type amorphous silicon films 22, 24 are genuine amorphous silicon thin films having, for example, the same composition. Further, the photoelectric conversion unit 20 is provided with the p-type amorphous silicon film 23 layered on the entire light-receiving surface of the i-type amorphous silicon film 22 and the n-type amorphous silicon film 25 layered on the entire rear surface of the i-type amorphous silicon film 24.

The light-receiving surface and the rear surface of the photoelectric conversion unit 20 (n-type single crystal silicon substrate 21) can be respectively formed as textured surfaces (not shown). The textured surface indicates an uneven surface which increases amount of light absorption by the photoelectric conversion unit 20 by restricting surface reflection. A specific example of the textured surface is an uneven surface having a pyramid shape (such as square pyramid and truncated pyramid) which can be obtained by applying anisotropic etching on the light-receiving surface and the rear surface of the n-type single crystal silicon substrate 21 having a (100) surface. It should be noted that the thickness of the photoelectric conversion unit 20 (the length of the film in the layered direction) is, for example, several hundred µm, most of which is the thickness of the n-type single crystal silicon substrate 21. The thickness of the amorphous silicon film is, for example, from several nm to several tens of nm. The height of unevenness of the texture structure is, for example, several µm. Therefore, the texture surface is reflected to the light-receiving surface and the rear surface of the amorphous silicon film.

As shown in FIGs. 1 and 3, the light-receiving surface electrode 30 includes a transparent conductive film 31, two or more finger electrode units 32, and two or more busbar electrode units 33. The finger electrode units 32 and the busbar electrode units 33 are electrically connected to each other, and both are formed on the transparent conductive film 31. That is, in the light-receiving surface electrode 30, carriers transmitted from the p-type amorphous silicon film23 via the transparent conductive film 31 are collected by the finger electrode units 32 and the busbar electrode units 33. When the photoelectric converter 10 is assembled in a module, the carriers collected by the busbar electrode units 33 which are electrically connected with the wire member are retrieved outside.

The transparent conductive film 31 may be a thin film (TCO film) including at least one of metal oxides having a polycrystalline structure, such as indium oxide (In₂O₃), zinc oxide (ZnO), tin oxide (SnO₂), and titanium oxide (TiO₂). The transparent conductive film 31 functions as a light transmissive electrode unit. In the transparent conductive film 31, a dopant such as tin (Sn), zinc (Zn), tungsten (W), antimony (Sb), titanium (Ti), aluminum (Al), cerium (Ce), and gallium (Ga) may be doped in the above metal oxides. The concentration of the dopant may be 0 to 20 wt%. The thickness of the transparent conductive film 31 may be, for example, 50 nm to 200 nm. It is preferable that the transparent conductive film 31 is layered on the entire surface region except for the edge area (hereinafter referred to as "edge area A1") on the light-receiving surface of the p-type amorphous silicon film 23. It is preferable that the edge area A1 on which the transparent conductive film 31 is not layered is a surface region having a width of about 1 to 2 mm from the edge of the light-receiving surface of the p-type amorphous silicon film 23, and provided annularly along the circumference of the light-receiving surface.

The finger electrode units 32 and the busbar electrode units 33 are thin line electrode units formed from conductive paste made from binder resin in which conductive particles such as silver (Ag) are dispersed. The finger electrode units 32 and the busbar electrode units 33 are provided to collect electrical power generated by the photoelectric conversion unit 20 via the transparent conductive film 31. The finger electrode units 32 may be, for example, strip-shaped metal layers formed on the light-receiving surface so as to evenly collect electrical power from the entire photoelectric conversion unit 20. It is preferable that the finger electrode units 32 are positioned parallel to each other with intervening spaces of a predetermined length (for example, width of 100 µm, and an intervening space of 2 mm).

The busbar electrode units 33 are provided to further collect the electrical power collected by the finger electrode units 32. The busbar electrode units 33 may be, for example, strip shaped metal layers formed on the light-receiving surface. The busbar electrode units 33 are positioned to intersect with the finger electrode units 32 to which the busbar electrode units 33 are electrically connected. The busbar electrode units 33 may be positioned, for example, parallel to each other with an intervening space of a predetermined length. It is preferable that the busbar electrode units 33 are arranged to be fewer and wider than the finger electrode units 32 (for example, width of 1.5mm, two pieces). It should be noted that the shapes of the finger electrode units 32 and the busbar electrode units 33 are not limited to the above mentioned shapes but various shapes such as a zigzag shape are also applicable.

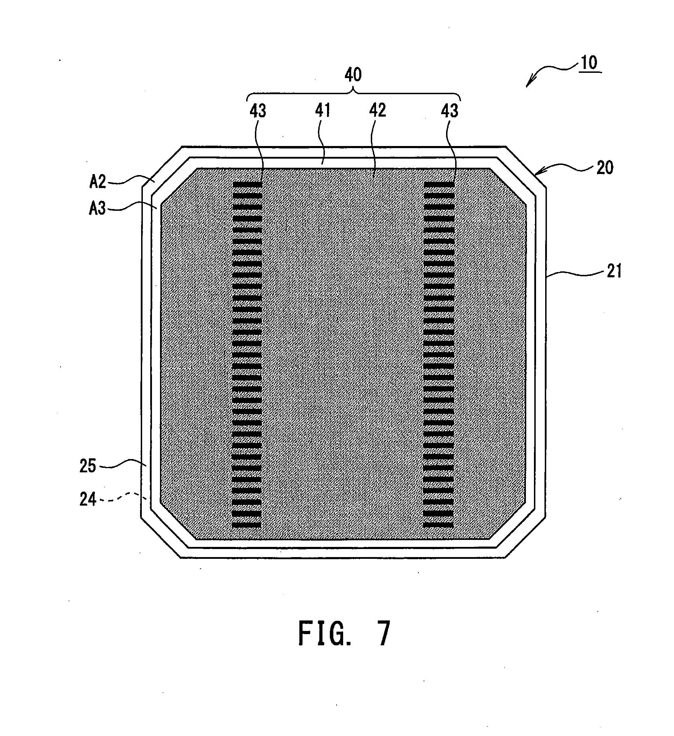

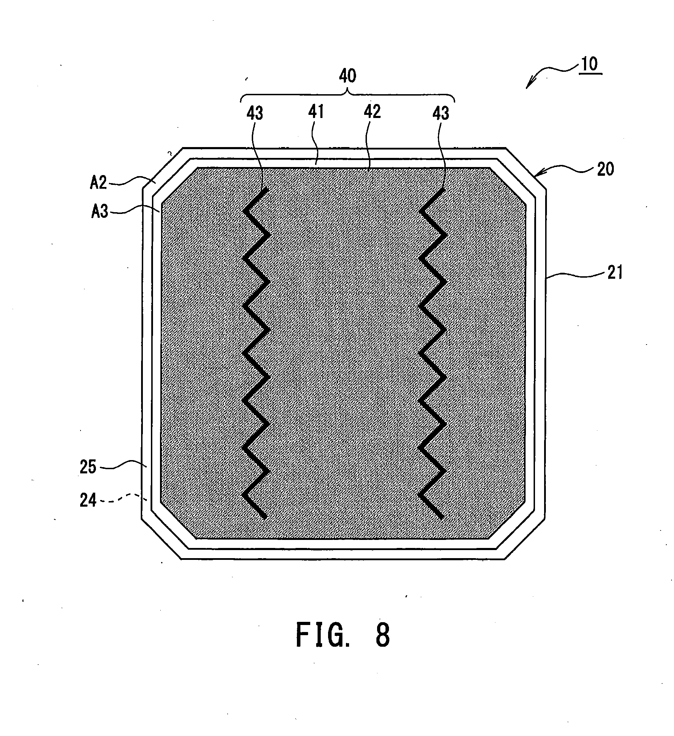

As shown in FIGs. 2 and 3, the rear surface electrode 40 includes the transparent conductive film 41, the metal film 42, and the two or more protruding electrodes 43. The protruding electrodes 43 are electrodes having a shape protruding in the direction of thickness of the photoelectric conversion unit 20 on the metal film 42. When the photoelectric converter 10 is assembled in a module, the wiring member is connected to the protruding electrodes 43. The protruding electrodes 43 may have a strip shape made from, for example, conductive paste on the metal film 42. For example, two protruding electrodes 43 may be positioned parallel to each other with an intervening space of a predetermined length in the same direction as the busbar electrode units 33. It should be noted that the shape of the protruding electrodes 43 is not limited to the above mentioned shape but various shapes such as a dot shape and zigzag shape are also applicable (refer to FIGs. 7 and 8 described below).

Similarly to the transparent conductive film 31, the transparent conductive film 41 may be formed from ITO, ZnO, SnO₂, or the like, and function as a light transmissive electrode unit. Further, as described in detail below, the transparent conductive film 41 prevents direct contact between the photoelectric conversion unit 20 and the metal film 42 and functions to raise the reflection ratio by interacting with the metal film 42. It is preferable that the transparent conductive film 41 has a thickness of about 50 nm to 200 nm and that the previously described texture surface is also applied to the rear surface of the transparent conductive film 41.

It is preferable that the transparent conductive film 41 is layered on the entire surface region except for the edge area (hereinafter referred to as "edge area A2") on the rear surface of the n-type amorphous silicon film 25. It is further preferable that the edge area A2 on which the transparent conductive film 41 is not layered is a surface region having a width of about 1 to 2 mm from the edge of the rear surface of the n-type amorphous silicon film 25, and provided annularly along the circumference of the rear surface.

The metal film 42 is a thin film made from a metal material having a high light reflection ratio and a high conductivity. The metal film 42 preferably has a high reflection ratio for light in the infrared region. The reflection ratio of the metal film 42 is preferably higher than that of the transparent conductive film 41 at least for light in the infrared region. The metal film 42 functions as an electrode which collects carriers transmitted from the n-type amorphous silicon film 25 via the transparent conductive film 41. The metal film 42 further has a function to reflect, to the light-receiving surface side, transmitted light which has passed through the photoelectric conversion unit 20. The metal film 42 is preferably thick enough to prevent light from passing through and thin enough to reflect the texture surface to the rear surface. For example, the metal film 42 preferably has a thickness of about 0.1 µm to 5 µm. By allowing the texture surface to also be reflected on the rear surface of the metal film 42, another advantage can be achieved that the contact between the metal film 42 and the protruding electrodes 43 becomes tighter.

Applicable metal material for the metal film 42 is a metal, for example, silver (Ag), aluminum (A1), titan (Ti), rhodium (Rh), copper (Cu), gold (Au), platinum (Pt), nickel (Ni), chrome (Cr), or an alloy including at least one of these metals. It is preferable that the metal material has a high reflective ratio to light in the infrared region, in particular, a wavelength of about 800 nm to 1200 nm. Among the above listed materials, Ag, Al, Ti, Rh, Cu, and Au, and an alloy including at least one of these materials, are preferable. Materials, Ag, Al, and Ti and an alloy including at least one of these materials are more preferable, and Ag and an alloy including Ag are particularly preferable.

The metal film 42 may be formed by two or more layered films made from the above metal materials. A layered body of AG film and Al film may be regarded as an example. In this case, the Ag film is preferably positioned on the transparent conductive film 41 side. An Ag-Al-Ag layered body in which both sides of the Al film are layered by Ag films, or, for example, an Ag-Cu-Ag layered body in which another metal film (such as Cu film) is used in place of the Al film may be used.

The metal film 42 may be layered on substantially the entire surface of the transparent conductive film 41 except for an edge area (hereinafter referred to as "edge area A3"). It is more preferable that the metal film 42 may be layered on the entire surface of the transparent conductive film 41 except for the edge area A3. It should be noted that "being layered on substantially the entire surface of the transparent conductive film 41 except for an edge area" includes a state where the metal film 42 can be recognized to be layered on substantially the entire surface of the transparent conductive film 41, which includes a case in which a part of the metal film 42 layered on the transparent conductive film 41 is missing. Specifically, a state where the metal film 42 covers more than 95% of the transparent conductive film 41 except for the edge area A3 can be raised as an example.

The metal film 42 is layered in at least part of the edge area A3 of the transparent conductive film 41 such that the metal film 42 does not cover the n-type amorphous silicon film 25 across the transparent conductive film 41. In other words, the metal film 42 may be layered on a part of the edge area A3. However, it is preferable that the metal film 42 is layered so as not to cover the n-type amorphous silicon film 25 beyond the transparent conductive film 41 on the entire circumference of the edge region A3 of the transparent conductive film 41. That is, it is preferable that, on the rear surface of the transparent conductive film 41, the metal film 42 is layered on the entire surface or substantially the entire surface except for the edge area A3.

The edge area A3 on which the metal film 42 is not layered is preferably narrow in consideration of reflection or the like of transmissive light. For example, it is preferable that the edge area A3 has a width of 1 mm to 5 mm from the edge of the transparent conductive film 41. The edge area A3 is preferably provided annularly along the circumference of the rear surface of the transparent conductive film 41. The width of the edge area A3 can be checked by cross-sectional observation using a scanning electron microscope (SEM) or transmission electron microscope (TEM) (an optical microscope can also be used with a wide width).

When the metal film 42 comes into contact with the edge area A2 of the n-type amorphous silicon film 25 beyond at least a part of the edge area A3 of the transparent conductive film 41, an issue of carrier trap may occur because the metal atoms of the metal film 42 may diffuse into the n-type amorphous silicon film 25 in that region to cause a defect energy level. However, because the metal film 42 is provided so as not to directly contact the rear surface of the photoelectric conversion unit 20 (n-type amorphous silicon film 25) via the transparent conductive film 41, it is possible to restrict occurrence of the defect energy level. It is preferable that the edge area A3 is provided annually along the entire circumference of the transparent conductive film 41 to avoid contact between the metal film 42 and the photoelectric conversion unit 20 (n-type amorphous silicon film 25) in the entire circumference of the photoelectric conversion unit 20. This results in restriction of the occurrence of the defect energy level.

When the photoelectric conversion unit 20 is configured to include an amorphous silicon film layered on a single crystal silicon substrate, the effect of the defect energy level caused by metals diffused into the amorphous silicon film increases. In such a case, an achievable advantage by preventing contact between the photoelectric conversion unit 20 and the metal film 42 becomes significant.

The metal film 42 is layered over a wide area of the rear surface of the photoelectric conversion unit 20 (n-type amorphous silicon film 25). In this way, the transmitted light that has entered from the light-receiving surface and passed through the photoelectric conversion unit 20 can be reflected to the light-receiving surface by the metal film 42. Therefore, the light absorption ratio at the photoelectric conversion unit 20 can be improved.

The metal film 42 is layered on the photoelectric conversion unit 20 via the transparent conductive film 41. In this way, the reflection ratio of the metal film 42 increases because light absorption is restricted by the occurrence of evanescent light. It should be noted that a texture surface is also applied on the rear surface of the photoelectric conversion unit 20. Therefore, light scatters on the rear surface making it easier for the photoelectric conversion unit 20 to capture light.

The transparent conductive film 41 has high adhesive properties with both of the photoelectric conversion unit 20 and the metal film 42. Therefore, it becomes possible to increase the adhesive strength (also known as peel strength) of the metal film 42.

Because of the above mentioned arrangements, light conversion efficiency can be improved by the photoelectric converter 10 according to the present embodiment.

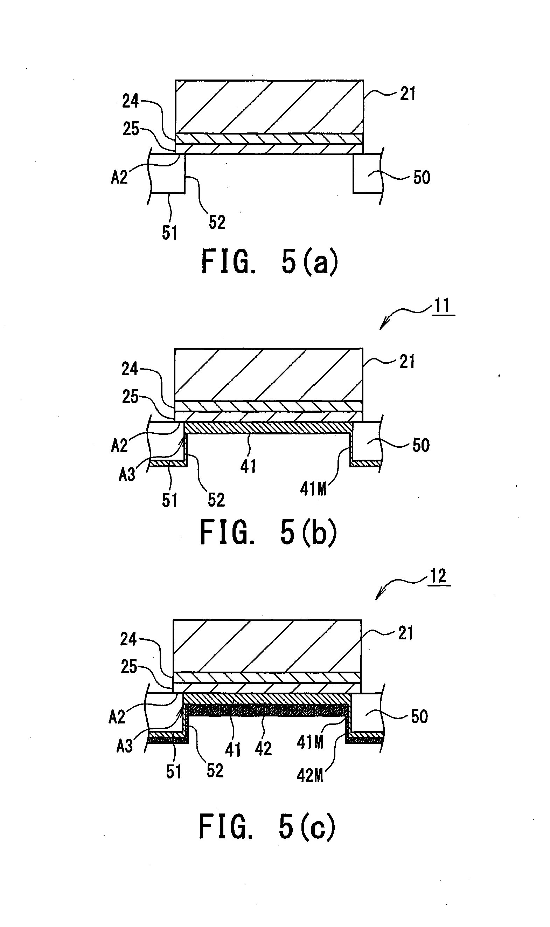

As shown in FIG. 4, at least a part of side surface of the metal film 42 may be covered by the transparent conductive film 41. In other words, the transparent conductive film 41 has a protruding portion which covers a side surface of the metal film 42 in the edge area A2. The "side surface" of the metal film 42 indicates a surface along the thickness of the metal film 42. The shape having the protruding portion can be obtained by, for example, a method in FIG. 5 described below. The protruding portion has a width of about several nm to several hundred nm and a height (the length in the direction of thickness) of about the same as the metal film 42. In such a configuration, the same effects as mentioned above can be achieved.

Next, a method for manufacturing the photoelectric converter 10 having the above configuration is described below.

With a clean n-type single crystal silicon substrate 21 provided in a vacuum chamber, the i-type amorphous silicon film 24 is layered on the substrate by, for example, plasma-enhanced chemical vapor deposition (plasma CVD). Next, n-type amorphous silicon film 25 is layered on the i-type amorphous silicon film 24. It should be noted that in the present embodiment, the surface of the n-type single crystal silicon substrate 21 on which the n-type amorphous silicon film 25 is layered is the rear surface. In the layering process of the i-type amorphous silicon film 24, for example, silane gas (SiH₄) is used as source gas. In the layering process of the n-type amorphous silicon film 25, for example, silane gas (SiH₄), hydrogen (H₂), or phosphine (PH₃) is used as source gas. In this way, the i-type amorphous silicon film 24 and the n-type amorphous silicon film 25 are layered in this order on the rear surface of the n-type single crystal silicon substrate 21.

The i-type amorphous silicon film 22 and the p-type amorphous silicon film 23 can also be layered on the light receiving surface of the n-type single crystal silicon substrate 21 by the plasma CVD method. In the layering process of thep-type amorphous silicon film 23, diborane (B₂H₆) is used as the source gas in place of PH₃. The finger electrode units 32 and the busbar electrode units 33 of the light-receiving surface electrode 30 can be formed by, for example, screen printing conductive paste in a desired pattern on the transparent conductive film 31. Alternatively, instead of the screen printing method, various method such as sputtering methods, evaporation methods, and plating methods may be applied. It should be noted that the transparent conductive film 31 can be layered by the same method for the transparent conductive film 41 (as described below).

By referring to FIG. 5, the process to manufacture the rear surface electrode 40, in particular, the layering process of the transparent conductive film 41 and the metal film 42 is described in detail below. In FIG. 5, a layer configuration of the n-type single crystal silicon substrate 21 on the light-receiving surface side is omitted. The film layered on the mask 50 is distinguished from the film layered on the rear surface of the n-type amorphous silicon film25byassigning "M" at the end of the reference numerals.

FIG. 5 (a) indicates a state in which the mask 50 is disposed on the rear surface of the n-type amorphous silicon film 25. The mask 50 is disposed to cover the edge area A2 on the rear surface of the n-type amorphous silicon film 25. Then, the transparent conductive film 41 is layered by, for example, a sputtering method on the rear surface of the n-type amorphous silicon film 25 on which the mask 50 has been disposed. As the mask 50, for example, a metal support frame which supports the n-type single crystal silicon substrate 21 from the rear surface may be used.

FIG. 5(b) shows an intermediate body 11 in which the transparent conductive film 41 is layered on the entire surface of the n-type amorphous silicon film 25 except for the edge area A2. When the transparent conductive film 41 has been layered, the transparent conductive film 41M is also attached to the mask 50. Specifically, the transparent conductive film 41M is attached not only on the surface 51 of the mask 50, but also on a side surface 52 of an opening. The transparent conductive film 41M attached to the side surface 52 of the opening has a thickness of, for example, about several nm to several hundred nm and is formed continuously with the transparent conductive film 41. Then, in a state in which the mask 50 with the transparent conductive film 41 attached is disposed, the metal film 42 is layered on the rear surface of the transparent conductive film 41 by, for example, a sputtering method.

FIG. 5(c) shows an intermediate body 12 in which the metal film 42 is layered on the entire rear surface of the transparent conductive film 41 except for the edge area A3. When the metal film 42 has been layered, the metal film 42M is also layered on the transparent conductive film 41M which is attached to the surface 51 and the side surface 52 of the opening. In other words, when the metal film 42 is layered, because the transparent conductive film 41M is attached to the side surface 52 of the opening, the metal film 42 is layered to the surface which is narrower by the thickness of the transparent conductive film 41M than the entire surface of the opening of the mask 50. That is, the transparent conductive film 41M attached to the side surface 52 of the opening functions as a mask to cover the edge area A3.

When the mask 50 is removed after the metal film 42 has been layered, the transparent conductive film 41 and the metal film 42 of the rear surface electrode 40 shown in FIG. 3 can be obtained. The transparent conductive film 41M and the metal film 42M attached to the mask 50 are removed together with the mask 50. As shown in FIG. 4, a part of the transparent conductive film 41M attached to the side surface 52 of the opening may be left as a protruding portion.

The protruding electrodes 43 maybe formed on the rear surface of the metal film 42 by the same method as the busbar electrode units33 (forexample, screenprintingmethods, sputteringmethods, evaporation methods, and plating methods). Alternatively, the protruding electrodes 43 may be formed by layering two or more films made of metal or alloy.

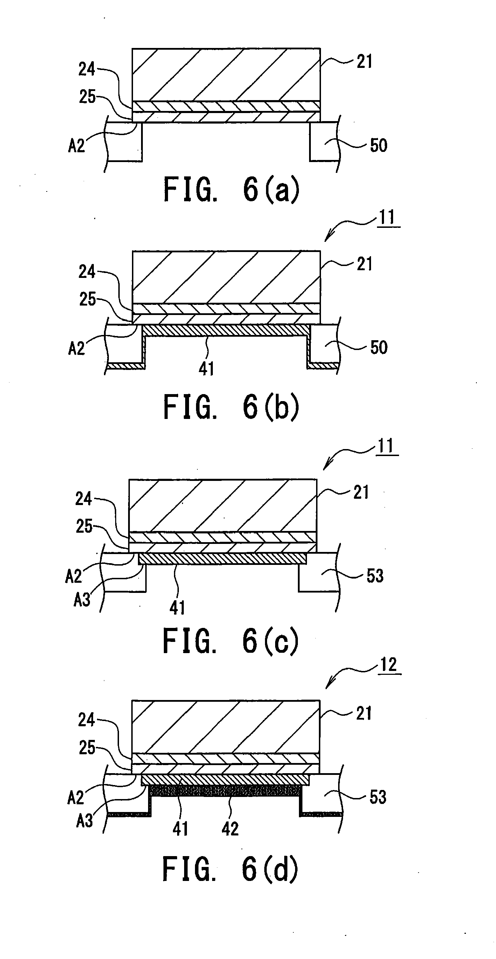

Another example of a method for manufacturing the photoelectric converter 10 is described below by referring to FIG. 6.

In the example shown in FIG. 6, the layering process (a, b) of the transparent conductive film 41 is the same as the example shown in FIG. 5, while the layering process (c, d) of the metal film 42 is different from the one shown in FIG. 5. Specifically, in the layering process of the transparent conductive film 41, the transparent conductive film 41 is layered on the entire surface except for the edge area A2 by using the mask 50. However, as shown in FIG. 6(c), in the layering process of the metal film 42, a second mask 53 which covers the edge area A3 on the rear surface of the transparent conductive film 41 is used in place of the mask 50.

As shown in FIG. 6(d), the metal film 42 is layered on the rear surface of the transparent conductive film 41 on which the second mask 53 is disposed. In this way, the metal film 42 can be layered on the entire surface of the transparent conductive film 41 except for the edge area A3. According to the method shown in FIG. 6 as an example, the width of the edge area A3 can be freely adjusted by changing the size of the opening of the second mask 53.

According to the present embodiment, designs can be arranged within a scope in which the object of the present invention can be achieved. For example, although the present embodiment describes, as an example, the photoelectric conversion unit 20 having a configuration in which amorphous silicon films are layered on both surfaces of the n-type single crystal silicon substrate 21, the configuration of the photoelectric conversion unit is not limited to this example. The photoelectric conversion unit may be configured to include no i-type amorphous silicon film 24 or n-type amorphous silicon film 25, or to include a semiconductor other than silicon (such as gallium arsenide). Further, although the p-type amorphous silicon film 23 side is assumed to be the light receiving surface side in the present embodiment, it is also possible to assume the n-type amorphous silicon film 25 side as the light-receiving side by providing the light-receiving surface electrode 30 on the n-type amorphous silicon film 25. Furthermore, although in the present embodiment the light-receiving surface electrode 30 and the rear surface electrode 40 are described to respectively include the busbar electrode units 33 and the protruding electrodes 43, the light-receiving surface electrode 30 or the rear surface electrode 40 may be so called busbarless electrodes having no busbar electrode units 33 or protruding electrodes 43.

In the present embodiment, the protruding electrodes 43 are described as, for example, unbroken linear lines. However, as shown in FIG. 7, two or more protruding electrodes 43 may be aligned like broken lines with intervening spaces therebetween. Although, in the example shown in FIG. 7, each of the protruding electrodes 43 has a rectangular shape which extends perpendicular to the broken line, the shape of the electrodes is not limited to this example. Each of the protruding electrodes 43 may have the shape of a string of dots or wavy edge lines with rough edges. Alternatively, as shown in FIG. 8, the protruding electrodes 43 may be formed as zigzag lines. It should be noted that although various shapes are described as examples of the shape of protruding electrodes 43, the busbar electrode units 33 may have various shapes similarly to the protruding electrodes 43.

### [REFERENCE NUMERALS]

10 photoelectric converter, 11, 12 intermediate body, 20 photoelectric conversion unit, 21 n-type single crystal silicon substrate, 22, 24 i-type amorphous silicon film, 23 p-type amorphous silicon film, 25 n-type amorphous silicon film, 30 light-receiving surface electrode, 31, 41 transparent conductive film, 32 finger electrode unit, 33 busbar electrode unit, 40 rear surface electrode, 42 metal film, 43 protruding electrode, 50 mask, 51 surface, 52 side surface of opening, and 53 second mask.

## Claims

1. A photoelectric converter comprising:
a photoelectric conversion unit;
a light-receiving surface electrode disposed on a light-receiving surface of the photoelectric conversion unit; and
a rear surface electrode disposed on a rear surface of the photoelectric conversion unit;
wherein the rear surface electrode comprises
a transparent conductive film layered on the rear surface of the photoelectric conversion unit; and
a metal film layered on substantially the entire surface of the transparent conductive film except for an edge area.

2. The photoelectric converter according to claim 1, wherein
the metal film is layered on the entire surface of the transparent conductive film except for the edge area.

3. The photoelectric converter according to claim 1 or 2, wherein
none of the metal film is layered on the entire circumference of the edge area on the transparent conductive film.

4. The photoelectric converter according to any one of claims 1 to 3, wherein
a reflection ratio of the metal film is higher than that of the transparent conductive film at least for light in an infrared region.

5. The photoelectric converter according to any one of claims 1 to 3, wherein
the metal film includes at least Ag.

6. The photoelectric converter according to any one of claims 1 to 5, wherein
the photoelectric conversion unit comprises:
a crystalline semiconductor substrate; and
an amorphous semiconductor film layered on a rear surface of the crystalline semiconductor substrate,
wherein the transparent conductive film is layered on a rear surface of the amorphous semiconductor film.

7. A method for manufacturing a photoelectric converter comprising:
providing a photoelectric conversion unit;
placing a mask covering at least a part of an edge area on the photoelectric conversion unit and layering a transparent conductive film on an area on the photoelectric conversion unit except for the edge area covered by the mask; and
with the transparent conductive film attached to the mask, layering a metal film on an area on the transparent conductive film.

8. A method for manufacturing a photoelectric converter comprising:
providing a photoelectric conversion unit;
placing a first mask covering at least a part of an edge area on the photoelectric conversion unit and layering a transparent conductive film on an area on the photoelectric conversion unit except for the edge area which is covered by the first mask; and
placing a second mask covering at least a part of an edge area on the transparent conductive film and layering a metal film on an area on the transparent conductive film except for the edge area covered by the second mask.
